# EUROPEAN PATENT APPLICATION

(11) **EP 1 852 859 A1**
(43) Date of publication of application: **07.11.2007**
(21) Application number: 06713310.8
(22) Date of filing: 08.02.2006
(51) Int. Cl.: G11B 7/24, G11B 7/253, G11B 7/26

(54) **SUBSTRATE FOR RECORDING MEDIUM AND METHOD FOR MANUFACTURING SAME**

(30) Priority: 18.02.2005 JP 2005042655
(71) Applicant: Pioneer Corporation, Tokyo 153-8654 (JP)
(72) Inventor: HOSODA, Yasuo, jimi 6-chome, Tsurugashima-shi, Saitama, (JP); IMAI, Tetsuya, jimi 6-chome, Tsurugashima-shi, Saitama, (JP); SHIDA, Noriyoshi, jimi 6-chome, Tsurugashima-shi, Saitama, (JP)
(74) Representative: Haley, Stephen
(86) International application number: PCT/JP2006/302167
(87) International publication number: WO 2006/087956

(57) **Abstract**

A main object of the present invention is to provide: an environmentally friendly substrate for recording medium which has good adhesion to a resin layer, and a manufacturing method thereof. To attain the object, the present invention provides a substrate for recording medium comprising: a resin substrate containing a separating material which blooms or bleeds toward its surface, a barrier layer which is formed on the resin substrate and made of a metal compound used to block the separating material, and a resin layer formed on the barrier layer.

## Description

### TECHNICAL FIELD

The present invention relates to: an environmentally-friendly substrate for recording medium which is used for optical discs such as DVDs (Digital Versatile Discs), card type recording mediums and the like, and a method for manufacturing the substrate for recording medium.

### BACKGROUND ART

Optical discs such as DVDs and card types are currently used as information recording mediums for recording and reproducing data such as image data, sound data, and computer data. As the substrates of optical discs and card type recording mediums, resin materials, such as polycarbonate, derived from petroleum are usually used.

When recording mediums of this kind are disposed as wastes after use, they are usually subjected to incineration or landfill disposal. In the case of incinerating wastes including plastics, there are problems such as that an incinerator is damaged and toxic gas is generated because of high calorific value of the wastes generated in the incineration. Also, when recording mediums such as those mentioned above are subjected to landfill disposal, they will remain as it is under the soil and left as semipermanent refuses so that giving rise to problems concerning an adverse influence on natural environment. However, since these recording mediums use materials derived from petroleum, there is a problem concerning exhaustion of resources.

In light of this, studies are being made as to the use of biodegradable resins and resins derived from organisms as the substrates of these recording mediums. However, these biogradable resins and resins derived from the organisms contain, as a separating material which blooms and bleeds toward the surface, components such as resin monomers or dimmers, fat and oil materials deriving form the organisms as raw materials, and the like. Therefore, when a resin layer made of a resin is formed on this substrate, there is the problem that the separating material which, for example, blooms toward the substrate deteriorates adhesion between the substrate and the resin layer over time, and making it difficult to put the substrate to practical use.

However, no prior art to the present invention has been found yet.

### DISCLOSURE OF THE INVENTION

### Problems to be Solved by the Invention

In view of the above situation, it is desired to provide a substrate for recording medium which is good in adhesion to the resin layer to be formed on the substrate and which is environmentally-friendly, and a method for manufacturing the substrate.

### Means for Solving the Problems

The present invention provides a substrate for recording medium comprising: a resin substrate containing a separating material which blooms or bleeds toward its surface, a barrier layer which is formed on the resin substrate and made of a metal compound used to block the separating material, and a resin layer formed on the barrier layer.

The present invention also provides a substrate for optical disc comprising: a resin substrate containing a separating material which blooms or bleeds toward its surface, a barrier layer which is formed on the resin substrate and made of a metal compound used to block the separating material, and a resin layer which is formed on the barrier layer and provided with a recording pit or a recording guide groove on its surface.

The present invention further provides a method for manufacturing a substrate for recording medium comprising steps of: a barrier layer-forming step of forming a barrier layer, made of a metal compound, on a resin substrate containing a separating material which blooms or bleeds toward its surface; and a resin layer-forming step of forming a resin layer on the barrier layer.

### BRIEF DESCRIPTION OF THE DRAWINGS

FIG. 1 is a schematic sectional view showing one example of a substrate for recording medium according to the present invention.
FIG. 2 is a schematic sectional view showing one example of a substrate for optical disc according to the present invention.
FIGS. 3A and 3B are a process diagram showing one example of a method for manufacturing a substrate for recording medium according to the present invention.

### EXPLANATION OF REFERENCES

- 1: Resin substrate
- 2: Barrier layer
- 3: Resin layer

### BEST MODE FOR CARRYING OUT THE INVENTION

The present invention relates to: a substrate for recording medium which is used for optical discs such as DVDs, card type recording mediums and the like; a substrate for optical disc using the substrate for recording medium; and a manufacturing method for the substrate for recording medium. Hereinafter, each of them will be explained.

### A. Substrate for recording medium

First, a substrate for recording medium of the present invention will be explained. The substrate for recording medium of the present invention comprises: a resin substrate containing a separating material which blooms or bleeds toward its surface, a barrier layer which is formed on the resin substrate and made of a metal compound used to block the separating material, and a resin layer formed on the barrier layer.

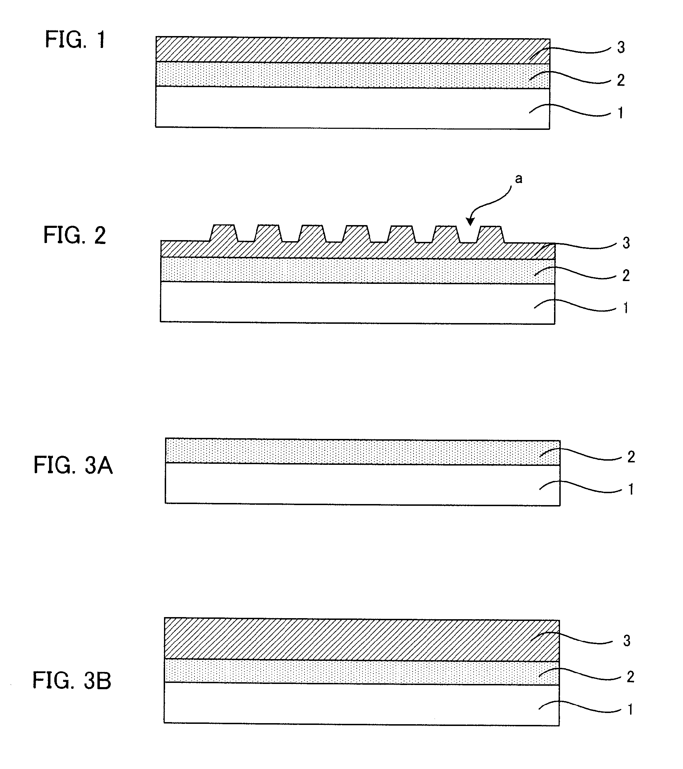

As shown in, for example, FIG. 1, the substrate for recording medium comprises a resin substrate 1 containing a separating material, a barrier layer 2 which is made of a metal compound and formed on the resin substrate 1, and a resin layer 3 formed on the barrier layer 2.

According to the present invention, since the barrier layer is formed between the resin substrate and the resin layer, the separating material can be prevented from moving to the resin layer side by the barrier layer even when the separating material blooms or bleeds toward the surface of the resin substrate. Therefore, a reduction in the adhesion of the resin layer caused by the separating material can be prevented, and a substrate for recording medium having high adhesion between each layer can be obtained.

This enables to use, for example, a biodegradable substrate or a substrate derived from organisms, in which a separating material generally tend to bloom or bleed toward its surface as the resin substrate, thereby developing a substrate for recording medium which is environmentally-friendly.

Each structure of the substrate for recording medium according to the present invention will be explained.

### 1. Resin substrate

First, the resin substrate to be used in the substrate for recording medium according to the present invention will be explained. Any material may be used as the resin substrate without limitation insofar as it contains the separating material that blooms or bleeds toward the surface and can form the barrier layer which will be explained later. Though different depending on the material for the resin substrate and other factors, examples of the separating material that blooms or bleeds toward the surface of the resin substrate include, non-polymer components such as monomers or dimers, and oil components which are usually contained in the resin components or generated by dissociation; oil components which are different from resin components contained in the organisms used as the raw materials, such as corn oil derived from corn raw materials or oil and fat components generated when corn oil is denatured, decomposed and bound; and additives to be added to resins in the production of pellets and substrates of these resins.

The type of resin substrate is appropriately selected in consideration to such as transparency, flexibility, shape, thickness and mechanical strength in accordance with the use of the substrate for recording medium. Substrates generally used in recording mediums may also be used. However, in the present invention, it is preferable to use a resin substrate containing, particularly, resins derived from organisms or biodegradable resins. This is because many of these resins derived from organisms or biodegradable resins contain the separating material and there are therefore many cases where adhesion to the resin layer which will be explained later is reduced by the blooming or bleeding of the separating material on the surface of the substrate. Also, this is because the use of the resin substrate using such a resin enables the production of an environmentally-friendly substrate for recording medium which has a little adverse influence on environment when, for example, the used resin substrates are disposed as wastes.

Specific examples of the resins derived from organisms or biodegradable resins include starch resins, cellulose resins, or aliphatic polyesters such as polylactic acid, polyglycolic acid and polycaprolactone.

In the resin substrate, only one type of resin may be contained, or two or more types of resins may be contained. In the latter case, the above-mentioned biodegradable resin or resin derived from organisms is contained by an amount of 10% or more, preferably in a range from 30% to 100%, and particularly in a range from 50% to 100% in the resin component of the resin substrate. This is because the influence of the resin substrate on environment can be thereby decreased.

In the present invention, it is particularly preferable to contain a starch resin in the resin substrate. Thereby, the production cost can be lowered while also obtaining mechanical strength sufficient for the substrate for recording medium.

In this case, the starch resin may be combined with resins such as polycarbonate, polypropylene, polyethylene or polylactic acid.

### 2. Barrier layer

Next, the barrier layer to be used in the present invention will be explained. Any layer may be used without limitation insofar as it is a layer: made of a metal compound, formed on the resin substrate, and can block the separating material. Examples of the barrier layer materials include oxides, nitrides, fluorides and carbides of metals. Specific examples of these compounds include TiO₂, SiO₂, Al₂O₃, SnO₂, ZnO, Bi₂O₃, Nb₂O₅, TiN, Si₂N₄, AlN, SnF₂ and SiC.

In the present invention, TiO₂ and SiO₂ among the above compounds are chemically stable, nontoxic, and relatively easily-available at low cost, and are therefore preferably used.

Further, the barrier layer may be formed in the same method as in the case of forming general metal compound layers. The barrier layer may be formed by a drying method such as a PVD method or a CVD method, or by a wet method such as a sol-gel method. In the present invention, particularly, the barrier layer is preferably formed by a sputtering method. This is because the metal compound may be strongly bound to the resin substrate by an anchoring effect and a substrate for recording medium having higher adhesion between the resin substrate and the barrier layer may be formed.

Here, the film thickness of the barrier layer is usually about 5 nm to 200 nm and preferably about 8 nm to 20 nm. This is because when the thickness of the barrier layer is less than the above range, there is a case where the separating material which bleeds or blooms toward the surface of the resin substrate cannot be prevented. Also, even if the film thickness exceeds the above range, an improvement in blocking effect is small, bringing about lower productivity which is disadvantageous costs and there is also a fear that a stress in the film causes cracks to be generated in the barrier layer. The film thickness is preferably up to about 20 nm, which is a thickness allowing the film to be formed in about 5 seconds with a general production apparatus, when productivity is taken into account.

### 3. Resin layer

Next, the resin layer used in the present invention will be explained. Any resin layer may be used in the present invention without limitation insofar as it is formed on the barrier layer. The type, film thickness, function and the like of the resin layer are properly selected in accordance with the use of the substrate for recording medium.

When the substrate for recording medium is used for an optical disc, the resin layer is designed to be a layer provided with a guide groove. When the substrate for recording medium is used as a card type recording medium, the resin layer may be formed as a coating layer, paint layer or the like.

As the material of the resin layer, materials used in resin layers used for general substrates for recording medium may be used. The materials of the resin layer may contain, for example, ultraviolet-curable resins, thermoset resins, thermoset and ultraviolet-curable resins or solvent-volatilized curable resins. Specific examples of these resins urethaneacrylate resins, epoxyacrylate resins, polyester resins, epoxy resins, acryl resins, urethane resins and melamine resins or mixtures of these resins. Further, resins obtained by adding pigments and additives to the above-mentioned resins may be used.

Also, there is no particular limitation to a method for forming such a resin layer and examples of the method include: a method of forming a resin layer by a general coating method on the barrier layer, a method of forming a resin layer by adhering a sheet-like layer to the barrier layer, and a method in which a resin layer having a specified shape is formed by embossing with a stamper or the like when the aforementioned resin is cured.

The film thickness of the resin layer as mentioned above is usually about 1 µm to 600 µm and preferably about 10 µm to 100 µm, though it may be selected in accordance with the type of the substrate for recording medium.

### 4. Substrate for recording medium

No particular limitation is imposed on the substrate for recording medium for the present invention insofar as it includes the above-mentioned resin substrate, the barrier layer and the resin layer. The substrate for recording medium may be provided with, for example, a primer layer between the resin substrate and the barrier layer or between the barrier layer and the resin layer. The formation of such primer layer has the advantage that adhesion of each layer can be further improved.

The primer layer may be, for example, a layer coated with a silane coupling agent or a layer to which HMDS (hexamethyldisilazane) is adhered by vapor treatment. Such a primer layer may have a minimum film thickness which enables the layer to obtain a stable effect. Specifically, the thickness of the primer layer is: about 0.1 µm to 5 µm and preferably about 0.5 µm to 1 µm in the case of the layer coated with a silane coupling agent; and preferably an extremely thin layer made of several molecules or monomolecular layer in the case of the layer with HMDS adhered.

### B. Substrate for optical disk

Next, the substrate for optical disk according to the present invention will be explained. The substrate for optical disk may comprise: a resin substrate containing a separating material which blooms or bleeds toward its surface, a barrier layer which is formed on the resin substrate and made of a metal compound to block the separating material, and a resin layer which is formed on the barrier layer and provided with a recording pit or recording guide groove on its surface. The substrate for optical disc is one obtained by forming a recording pit constituted of concave-convex portions or recording guide groove on the surface of the resin layer in the above-mentioned substrate for recording medium. As shown in, for example, FIG. 2, the substrate for optical disc comprises a resin substrate 1, a barrier layer 2 formed on the substrate 1, and a resin layer 3 which is formed on the barrier layer 2 and provided with a guide groove "a".

According to the present invention, the barrier layer is formed between the resin layer and the resin substrate and therefore, the adhesion of the resin layer can be improved even when a resin substrate containing a separating material which blooms or bleeds toward the surface of the resin substrate is used. Therefore, a substrate containing a starch resin may be used as an example of the resin substrate, thereby developing an environmentally-friendly substrate for optical disc.

The resin substrate to be used in the substrate for optical disc according to the present invention will be explained. The resin substrate and barrier layer to be used in the substrate for optical disc according to the present invention may have the same structures as those explained in the paragraph "A. Substrate for recording medium" and detailed explanations of these parts are therefore omitted.

### (Resin layer)

The resin layer to be used in the present invention is formed on the barrier layer and formed with a recording pit or recording guide groove. This resin layer may be formed, for example, by applying a resin layer-forming coating solution containing an ultraviolet-curable resin or a thermoset and ultraviolet curable resin to the barrier layer and by curing using heat or ultraviolet light in the condition that the coating layer is embossed by a stamper or the like. Alternatively, an adhesive sheet for forming a resin layer which contains an ultraviolet-curable resin or a thermoset and ultraviolet curable resin may be applied to the barrier layer and embossed by a stamper or the like to form the resin layer. As the stamper, one which is generally used in the formation of optical discs may be used. Further, examples of the material used to form the resin layer include acryl resins and urethaneacrylate resins.

Also, as to the film thickness of the resin layer provided with a guide groove, the average film thickness of the resin layer is usually about 1 µm to 600 µm, and preferably about 10 µm to 100 µm, though it may be selected according to the type of the substrate for recording medium.

### (Substrate for optical disk)

Any substrate may be used without limitation insofar as it comprises the above-mentioned resin substrate, a barrier layer, and a resin layer provided with a recording pit or recording guide groove. For example, the substrate for optical diskmaybe optionally provided with a primer layer and the like between the barrier layer and the resin layer or between the resin substrate and the barrier layer.

### C. Method for manufacturing a substrate for recording medium

Next, the manufacturing method for a substrate for recording medium according to the present invention will be explained. The method for manufacturing a substrate for recording medium of the present invention comprises: a barrier layer-forming step of forming the barrier layer, made of the metal compound, on the resin substrate containing the separating material which blooms or bleeds toward its surface; and a resin layer-forming step of forming the resin layer on the barrier layer.

The method for manufacturing a substrate for recording medium according to the present invention comprises, as shown in FIGS. 3A and 3B, a barrier layer-forming step (FIG. 3A) for forming a barrier layer 2 made of a metal compound on a resin substrate 1; and a resin layer-forming step (FIG. 3B) for forming a resin layer 3 on the barrier layer 2.

In the method for manufacturing a recording medium according to the present invention, the barrier layer-forming step is carried out to form the barrier layer on the surface of a resin substrate. Therefore, a separating material can be prevented from moving to the resin layer side by the barrier layer even when the separating material blooms or bleeds toward the surface of the resin substrate. Therefore, the influence of lower molecules, contained in the resin substrate, on the adhesion of the resin layer which is formed on the barrier layer can be prevented, and a substrate for recording medium provided with a resin layer having high adhesion can be obtained. Also, when the barrier layer is formed by a sputtering method, the anchoring effect of the barrier layer can bring about high adhesion between the barrier layer and the resin substrate. Therefore, a substrate for recording medium in which adhesion between each layer is high can be made.

In the present invention, since a substrate using a biogradable resin or a resin derived from organisms may be used as the resin substrate, the present invention has the advantage that a substrate for recording medium which is environmentally-friendly can be obtained. Each step in the method for manufacturing a substrate for recording medium according to the present invention will be explained in detail.

### 1. Barrier layer-forming step

The barrier layer forming step of the present invention will be explained. The barrier layer forming step is a step of forming the barrier layer, which is made of the metal compound, on the resin substrate containing the separating material that blooms or bleeds toward its surface. A drying method such as a PVD method or CVD method or a wet method such as a sol-gel method may be used in forming the barrier layer. In the present invention, particularly, the barrier layer is preferably formed by a sputtering method. This is because the adhesion of the barrier layer to the resin substrate can be made high and a substrate for recording medium having high adhesion between each layer can be obtained. As the sputtering method, a method may be adopted in which a metal compound such as a metal or an oxide, nitride, fluoride or carbide of a metal is used as the target raw material and argon gas, oxygen gas, nitrogen gas or the like is introduced to carry out sputtering.

At this time, the film thickness of the barrier layer to be formed is usually about 5 nm to 200 nm and preferably about 8 nm to 20 nm. This is because the separating material which bleeds or blooms toward the surface of the resin substrate can be prevented from moving to the resin layer which is to be formed in the resin layer-forming step (to be explained later), and a substrate for recording medium having high adhesion between each layer can be obtained.

The resin substrate, metal compound and the like which are to be used in this step may be designed to have the same structures as those explained in the paragraph "A. Substrate for recording medium", and detailed explanations thereof are therefore omitted.

### 2. Resin layer-forming step

Next, the resin layer-forming step will be explained. The resin layer-forming step is a step of forming the resin layer on the barrier layer. The method of forming the resin layer is properly selected corresponding to such as the type of resin layer. As the method of forming the resin layer, the following method may be used: a method in which the resin layer is formed by applying a coating solution containing an ultraviolet-curable resin, thermoset resin, thermoset and ultraviolet-curable resin or solvent volatilized curable resin to the surface of the barrier layer and by curing using ultraviolet light or heat or by drying. Alternatively, a sheet obtained by molding an ultraviolet-curable resin, thermoset resin or a thermoset and ultraviolet curable resin may be adhered to the barrier layer to form the resin layer. Further, when the substrate for recording medium produced in accordance with the present invention is used for an optical disc, a method may be adopted in which the above-mentioned resin is cured under the condition that the coating layer is embossed by, for example, a stamper so as to form a recording pit or a recording guide groove on the surface of the resin layer.

The film thickness of the resin layer to be formed in this step is usually about 1 µm to 600 µm and preferably about 10 µm to 100 µm, though it is properly selected according to the type of the resin layer.

The resin and the like which are used in the formation of the resin layer in this step may be designed to have the same structures as those explained in the paragraph "A. Substrate for recording medium", and detailed explanations thereof are therefore omitted.

### 3. Others

Other than the barrier layer-forming step and the resin layer-forming step, the method for manufacturing a substrate for recording medium according to the present invention may comprise, for example, a step of forming a primer layer on the resin substrate to improve adhesion to the barrier layer, and a step of forming a primer layer on the barrier layer to improve adhesion to the resin layer according to the need.

The present invention is not limited to the above-mentioned embodiments. The embodiments are merely examples, and any one having the substantially same configuration as the technological idea disclosed in the claims of the present invention and the same effects is included in the technological scope of the present invention.

### EXAMPLES

### [Example 1]

A barrier layer (TiO₂) of 10 nm in thickness was formed on a circular substrate of 12 cm diameter made of a starch resin (trade name: Corn Starch Resin WO-100, manufactured by NISSHO MUSEN Co., Ltd.) by a sputtering method. In succession, a ultraviolet-curable resin (manufactured by Mitsubishi Rayon Co., Ltd., acryl based ultraviolet-curable resin) was applied to the barrier layer and cured under the condition that it was embossed by a clear stamper to form a resin layer having a spiral groove (guide groove) with a 0.320 µm pitch, to make a substrate for optical disc of the present invention.

### (Evaluation)

A reflecting film (Al-Pd-Sn-O), a dielectric protective layer (Nb-Si-0-N), a recording film layer (Bi-Ge-N) and a dielectric protective layer (Nb-Si-0-N) were laminated in this order on the above-mentioned substrate for optical disc by a sputtering method. These films and layers had film thicknesses of 50 nm, 30 nm, 15 nm and 24 nm respectively. Thereafter, a polycarbonate sheet of 0.1 mm in thickness was applied as an incident side substrate (cover layer) on the dielectric protective layer by using an ultraviolet-curable resin as an adhesive.

A 1-7 modulation random pattern was recorded on the surface of the guide groove of the optical disc, which is convex with respect to the incident side, at a linear velocity of 4.92 mm/s by using an optical head which radiated light having a wavelength of 405 nm and in which the numerical aperture of the objective lens was 0.85. In the recording, a multi-pulse was used and the window width was set to 15.15 nsec. After the recording was finished, the jitter value was measured. A good jitter value of 6.3% was obtained and it was confirmed that the optical disc can sufficiently stand practical use.

### [Example 2]

A barrier layer (TiO₂) of 5 nm in thickness was formed on a substrate made of a starch resin (trade name: Corn Starch Resin WO-100, manufactured by NISSHO MUSEN Co., Ltd.) by a sputtering method. In succession, a ultraviolet-curable resin (manufactured by DAINIPPON INK AND CHEMICALS, Inc., acryl based ultraviolet-curable resin SD-693) was applied by a thickness of 100 µm to form a substrate for recording medium of the present invention.

### [Example 3]

A substrate for recording medium was formed in the same manner as in Example 2 except that a barrier layer was formed by a thickness of 8 nm.

### [Example 4]

A substrate for recording medium was formed in the same manner as in Example 2 except that a barrier layer was formed by a thickness of 10 nm.

### [Example 5]

A substrate for recording medium was formed in the same manner as in Example 2 except that SiO₂ was used to form a barrier layer.

### [Example 6]

A substrate for recording medium was formed in the same manner as in Example 5 except that a ultraviolet-curable resin (manufactured by Mitsubishi RayonCo., Ltd., acrylbasedultraviolet-curableresin) was used to form a resin layer.

### [Comparative Example]

A substrate for recording medium was formed in the same manner as in Example 2 except that no barrier layer was formed.

### (Evaluation)

The products obtained in Examples 2 to 6 and Comparative Example were respectively subjected to a lattice pattern tape-peeling test according to JIS K5400-1990 to measure the condition of the surfaces of the ultraviolet-cured resin layer of the above-mentioned substrates for recoding medium. Using a cellophane tape (trade name: "CT18", manufactured by NICHIBAN CO., LTD.), the respective surface was adhered to the tape by using a finger pad and an eraser, and then, the tape was peeled off at right angle with the surface. The peeling state was determined by the number of unpeeled squares out of 100 squares: the case where the ultraviolet-curable resin layer was unpeeled was rated as 100/100, and the case where the ultraviolet-curable resin layer was completely peeled off was rated as 0/100. The results of each case are shown in Table 1.

**[Table 1]**

| | Example 2 | Example 3 | Example 4 | Example 5 | Example 6 | Comparative Example |
|---|---|---|---|---|---|---|
| Type of barrier layer | TiO₂ | TiO₂ | TiO₂ | SiO₂ | SiO₂ | - |
| Film thickness of the barrier layer | 5nm | 8nm | 10nm | 10nm | 10nm | - |
| Degree of peeling (10 minutes after the resin layer is formed) | - | - | - | - | - | 55/100 |
| Degree of peeling (one hour after the resin layer is formed) | 98/100 | 99/100 | - | 100/100 | 100/100 | 2/100 |
| Degree of peeling (6 hours after the resin layer is formed) | 56/100 | 94/100 | - | 100/100 | 100/100 | 0/100 |
| Degree of peeling (70 hours after the resin layer is formed) | 28/100 | 96/100 | - | - | - | 0/100 |
| Degree of peeling (140 hours after the resin layer is formed) | 0/100 | - | - | - | - | |
| Degree of peeling (240 hours after the resin layer is formed) | - | 99/100 | 100/100 | - | - | - |

It was confirmed from the above-shown results that the adhesion of the resin layer could be more improved in the case of forming the barrier layer than in the case of forming no barrier layer. It was also confirmed that if the film thickness of the barrier layer was designed to be 5 nm, the adhesion of the resin layer could be relatively bettered and further, if the film thickness of the barrier layer was 8 nm or more, the adhesion of the resin layer could be sufficiently improved. Also, it was confirmed that the same effect was obtained even when the barrier layer or the resin layer was altered.

## Claims

1. A substrate for recording medium comprising:
a resin substrate containing a separating material which blooms or bleeds toward a surface of the resin substrate,
a barrier layer which is formed on the resin substrate and made of a metal compound used to block the separating material, and
a resin layer formed on the barrier layer.

2. The substrate for recording medium according to Claim 1, **characterized in that** the resin substrate contains a starch resin.

3. A substrate for optical disc comprising:
a resin substrate containing a separating material which blooms or bleeds toward a surface of the resin substrate,
a barrier layer which is formed on the resin substrate and made of a metal compound used to block the separating material, and
a resin layer which is formed on the barrier layer and provided with a recording pit or a recording guide groove on a surface of the resin layer.

4. A method for manufacturing a substrate for recording medium comprising steps of:
a barrier layer-forming step of forming a barrier layer, made of a metal compound, on a resin substrate containing a separating material which blooms or bleeds toward a surface of the resin substrate; and
a resin layer-forming step of forming a resin layer on the barrier layer.

5. The method for manufacturing a substrate for recording medium according to Claim 4, **characterized in that** the barrier layer-forming step is a step of forming the barrier layer by a sputtering method.
